# EUROPEAN PATENT APPLICATION

(11) **EP 3 480 288 A1**
(43) Date of publication of application: **08.05.2019**
(21) Application number: 17200364.2
(22) Date of filing: 07.11.2017
(51) Int. Cl.: C11D 7/10, C11D 7/32, C11D 7/50, C11D 11/00, H01L 21/02, H01L 21/311

(54) **FLUORIDE BASED CLEANING COMPOSITION**

(71) Applicant: Henkel AG & Co. KGaA, 40589 Düsseldorf (DE)
(72) Inventor: KOUCHI, Takuma, Yokohama, Kanagawa 235-0017 (JP); KIKUCHI, Kazuo, Yokohama, Kanagawa 235-0017 (JP); OTAKE, Atsushi, Yokohama, Kanagawa 235-0017 (JP)

(57) **Abstract**

The present invention relates to a cleaning composition comprising a) from 1 to 5% by weight of total weight of the composition of ammonium fluoride; b) from 30 to 70% by weight of total weight of the composition of a water soluble organic solvent; c) from 1.5 to 20% by weight of total weight of the composition of organic amine; and d) from 31 to 60% by weight of total weight of the composition of deionised water. A cleaning composition according to the present invention provides good cleaning efficacy, while being gentle cleaning composition and having a stable pH.

## Description

### Technical field of the invention

The present invention relates to a fluoride based cleaning composition suitable for semiconductor wafer cleaning.

### Background of the invention

The fabrication of semiconductor devices such as integrated circuits and large scale integrations, as well as liquid-crystal panel apparatus and other display panel apparatus, comprises the steps of forming a uniform photoresist coating over metallic layers or insulating layers; performing desired exposure and development to form a photoresist pattern; etching (selectively) the substrate having the metallic layers or the insulating layers by chemical vapour deposit using the photoresist pattern as a mask to form a microcircuit; and removing one or more of unwanted photoresist layer, etching residue, residual photoresist, and photoresist by-products from a substrate with a liquid stripper. Various organic liquid photoresist stripping solutions have been used to remove the unwanted photoresist layer, etching residue, residual photoresist, and photoresist by-products from a substrate. The prior art frequently employs compositions containing fluorine compounds, such as hydrofluoric acid in photoresist stripping solutions for removing unwanted photoresist layer.

One kind of photoresist stripping solution described in the prior art mainly comprises (a) a salt of hydrofluoric acid with a metal-free base, (b) a water-soluble organic solvent, and (c) water, and has a pH of 5 to 8. Problems relating to this kind of solutions are often around the quantity of salt of hydrofluoric acid, lower quantities leading to poor cleaning effectiveness, whereas higher quantities leading to solubility issues.

Another kind of photoresist stripping solutions comprise a basic substance to adjust the pH of the solution. Example of this kind of composition comprises (a) a salt of hydrofluoric acid with base free from metal ions: (b) a water-soluble organic solvent; (c) a basic substance; and (d) water. Generally, preferred pH value is from 8.5 to 10.0 in this kind of solutions, and the prior art indicates that such pH value can be achieved by small amount of basic substance 0.1 - 0.3 wt%. Problem underlying this kind of solution is that pH decreases significantly by dilution with water. Furthermore, there are concerns relating to aluminium metal corrosion due water rinsing.

Prior art also discloses a buffered cleaning compositions containing a salt of hydrofluoric acid. Typically these compositions have pH from 7 to 11. This pH range is preferred because of low damage on the TEOS (silicon dioxide film made by chemical vapor deposition of tetraethyl orthosilicate). The buffering system contributes stability of the pH value, however, the pH still fluctuates when the cleaning composition is diluted with water.

Therefore, there is still a need for a cleaning composition providing a high cleaning efficiency, while having a stable pH value during dilution with water, and being gentle and not causing a damage to dielectric materials such as SiO₂ and metal layers such as aluminium and aluminium alloys.

### Short description of figures

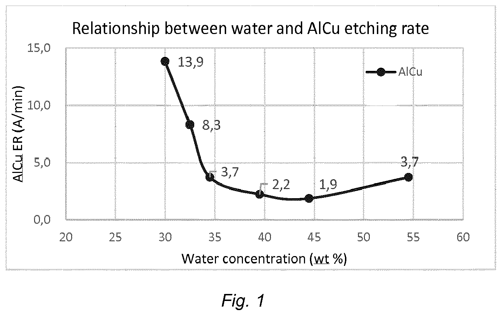

Figure 1 illustrates a relationship between water and AlCu etching rate (ER).

### Summary of the invention

The present invention relates to a cleaning composition comprising a) from 1 to 5% by weight of total weight of the composition of ammonium fluoride; b) from 30 to 70% by weight of total weight of the composition of a water soluble organic solvent; c) from 1.5 to 20% by weight of total weight of the composition of organic amine; and d) from 31 to 60% by weight of total weight of the composition of deionised water.

The present invention relates to a use of a composition according to the present invention in semiconductor cleaning.

The present invention also encompasses a process of removing one or more of etching residue, residual photoresist, and photoresist by-products from a substrate, comprising steps of: contacting a substrate having one or more of etching residue, residual photoresist, and photoresist by-products present thereon with a composition according to the present invention.

### Detailed description of the invention

In the following passages the present invention is described in more detail. Each aspect so described may be combined with any other aspect or aspects unless clearly indicated to the contrary. In particular, any feature indicated as being preferred or advantageous may be combined with any other feature or features indicated as being preferred or advantageous.

In the context of the present invention, the terms used are to be construed in accordance with the following definitions, unless a context dictates otherwise.

As used herein, the singular forms "a", "an" and "the" include both singular and plural referents unless the context clearly dictates otherwise.

The terms "comprising", "comprises" and "comprised of" as used herein are synonymous with "including", "includes" or "containing", "contains", and are inclusive or open-ended and do not exclude additional, non-recited members, elements or method steps.

The recitation of numerical end points includes all numbers and fractions subsumed within the respective ranges, as well as the recited end points.

All percentages, parts, proportions and then like mentioned herein are based on weight unless otherwise indicated.

When an amount, a concentration or other values or parameters is/are expressed in form of a range, a preferable range, or a preferable upper limit value and a preferable lower limit value, it should be understood as that any ranges obtained by combining any upper limit or preferable value with any lower limit or preferable value are specifically disclosed, without considering whether the obtained ranges are clearly mentioned in the context.

All references cited in the present specification are hereby incorporated by reference in their entirety.

Unless otherwise defined, all terms used in disclosing the invention, including technical and scientific terms, have the meaning as commonly understood by one of the ordinary skill in the art to which this invention belongs to. By means of further guidance, term definitions are included to better appreciate the teaching of the present invention.

The present invention relates to a cleaning composition comprising a) from 1 to 5% by weight of total weight of the composition of ammonium fluoride; b) from 30 to 70% by weight of total weight of the composition of a water soluble organic solvent; c) from 1.5 to 20% by weight of total weight of the composition of organic amine; and d) from 31 to 60% by weight of total weight of the composition of deionised water.

A cleaning composition according to the present invention contains a relatively high quantity of ammonium fluoride to provide a high cleaning efficiency, however, despite of the high quantity, ammonium fluoride remains soluble. In addition, the cleaning composition according to the present invention has a stable pH value when diluted with water. Furthermore, the cleaning composition according to the present invention is a gentle cleaning solution, and does not damage dielectric materials such as SiO₂ and metal layers such as aluminium and aluminium alloys.

According to the present invention more than 1% ammonium fluoride in a composition is considered to be high quantity and less than 0.1% ammonium fluoride in a composition is considered to be low quantity. In general, high ammonium fluoride quantity is good for cleaning, however, high quantity may cause solubility problems and causes damage on metal surfaces (Al, AlCu, Cu) and dielectric material (SiO₂). Generally, a low ammonium fluoride quantity does not cause a damage, however, cleaning efficacy is adversely affected.

A cleaning composition according to the present invention comprises a high quantity of ammonium fluoride. Ammonium fluoride is used because it helps to achieve high concentration of fluoride anion, which leads to high cleaning effectiveness. Despite of having a high ammonium fluoride quantity in a composition, it does not cause a damage to Al, AlCu, Cu and SiO₂ (TEOS) surfaces.

Suitable commercially available ammonium fluorides for use in the present invention are for example but not limited to electronic grade ammonium fluoride solution 40% from Morita Chemical Industories CO., Ltd. and ammonium fluoride (40%) from Kanto Chemical Co., Inc.

A cleaning composition according to the present invention comprises ammonium fluoride from 1 to 5% by weight of total weight of the composition, preferably from 2 to 4% and more preferably from 2.5 to 3.5%.

If the quantity of ammonium fluoride is less than 1%, the cleaning effectiveness decreases, and whereas the quantity is more than 5%, the ammonium fluoride is not soluble in solvent rich solutions.

A cleaning composition according to the present invention comprises a water soluble organic solvent. Suitable water soluble organic solvent promotes solubility of other ingredients in the cleaning composition, and in addition, it provides good cleaning effectiveness.

Suitable water soluble organic solvent for use in the present invention is selected from the group consisting of N-methylpyrrolidone (NMP), dimethyl sulfoxide (DMSO), methyl diglycol (MDG), buthyl diglycol (BDG), N,N-dimethylformamide, N,N-dimethylacetamide, γ-butyrolactone, ethylene glycol, propylene glycol and mixtures thereof, preferably said solvent is selected from N-methylpyrrolidone (NMP), dimethyl sulfoxide (DMSO) and mixtures thereof.

DMSO is preferred water soluble organic solvent because it promotes an excellent solubility of ammonium fluoride. DMSO also promotes the solubility of the resin to be removed from the surface.

In one embodiment, the cleaning composition according to the present invention comprises mixture of one or more water soluble organic solvent with DMSO. Additional water soluble organic solvent is not specifically restricted so long as it is miscible with water and DMSO. Examples of such water soluble organic solvents include but are not limited to N-methylpyrrolidone (NMP), methyl diglycol (MDG), buthyl diglycol (BDG). N-methylpyrrolidone (NMP) is preferred to use in combination with DMSO because it provides good cleaning effectiveness.

Suitable commercially available water soluble organic solvents for use in the present invention are for example but not limited to DMSO from Toray Fine Chemical Co., Ltd., N-Methyl-2-Pyrrolidone (NMP) from Mitsubishi Chemical Corporation and N-methyl-2-pyrrolidone (dist.) from BASF SE.

A cleaning composition according to the present invention comprises a water soluble organic solvent from 30 to 70% by weight of total weight of the composition, preferably from 35 to 65% more preferably from 45 to 65%, and even more preferably from 50 to 61%.

If the organic solvent quantity is less than 30%, the composition is water-rich accordingly and would cause damage on Al, Cu and AlCu surfaces. Whereas too high organic solvent quantity is more than 70% leading poor solubility of ammonium fluoride.

When combination of solvents DMSO and NMP is used the ratio of DMSO:NMP is preferably from 99:1 to 10:90, more preferably from 50:50 to 20:80.

A cleaning composition according to the present invention contains an organic amine. Organic amine provides pH stability for the composition when diluted with water. Decreasing pH value has a concern of corrosion of metals such as aluminum and aluminum alloys. Organic amine promotes to reduce damage on silicon oxide. Furthermore, organic amine promotes solubility of ammonium fluoride.

Suitable organic amine for use in the present invention is selected from the group consisting of monoethanolamine, diethanolamine, triethanolamine, monoisopropanolamine, 2-(2-aminoethylamino) ethanol, 2-amino-2-methyl-1-propanol, N-methylethanolamine, 2-(dimethylamino)ethanol, ethylenediamine, propylenediamine and mixtures thereof, preferably said organic amine is monoethanolamine, triethanolamine.

Triethanolamine is preferred organic amine because it provides pH stability and it promotes swelling and dissolving of the resin to be removed from the surface.

Suitable commercially available organic amines for use in the present invention are for example but not limited to triethanolamine (pure) and monoethanolamine (pure) from BASF SE; triethanolamine DOW™ and monoethanolamine DOW™ from the Dow Chemical Company.

A cleaning composition according to the present invention comprises an organic amine from 1.5 to 20% by weight of total weight of the composition, preferable from 2 to 15%, more preferably from 2.5 to 12.5% and even more preferably from 3.5 to 5%.

When the organic amine quantity is less than 1.5 %, pH fluctuates when the composition is diluted with water, and TEOS is damaged, whereas quantity higher than 20 %, the composition causes damages on Al and AlCu surfaces.

A cleaning composition according to the present invention comprises water. Water promotes solubility of ammonium fluoride and AlCu etching rate.

Water used in the composition according to the present invention, must be deionized water. because metal ion contamination provides negative impact on electrical properties of semiconductor devices. The purity of deionized water is characterized by electrical resistivity. The electrical resistivity is preferably for the deionised water suitable for use in the present invention more than 15M Ω/cm, more preferably more than 17M Ω/cm, and even more preferably more than 18MΩ/cm. Resistivity can be measured by using HE-480Rfrom HORIBA of Ltd. and Ultrameter II™ from Myron L® Company.

A cleaning composition according to the present invention comprises water from 31 to 60% by weight of total weight of the composition, preferably from 32 to 50%, more preferably from 32 to 45%, and even more preferably from 32 to 40%.

If the water quantity is less than 31 % the solubility of ammonium fluoride decreases, whereas if the quantity is over 60% the composition will cause a damage to Al, Cu and AlCu surfaces.

A composition according to the present invention may further comprise an acid. Suitable acid for use in the present invention can be an organic acid or inorganic acid, preferably an organic acid.

An organic may be added to the composition according to the present invention to adjust pH, to act as a pH buffer, corrosion inhibitor or chelating agent.

Suitable organic acid for use in the present invention may be selected from the group consisting of formic acid, acetic acid, propionic acid, butyric acid, isobutyric acid, oxalic acid, malonic acid, succinic acid, glutaric acid, maleic acid, fumaric acid, benzoic acid, phthalic acid, 1,2,3-benzenetricarboxylic acid, glycolic acid, lactic acid, malic acid, citric acid, tartaric acid, and mixtures thereof.

A composition according to the present invention may comprise an organic acid from 0.1 to 10.0 % by weight of total weight of the composition, preferably from 0.5 to 5.0 %, and more preferably from 1.0 to 3.0 %.

Suitable commercially available organic acids for use in the present invention are for example but not limited to citric acid monohydrate and citric acid anhydrous from Showa Kako Corporation.

A cleaning composition according to the present invention may further comprise one or more additional components selected from a surfactant selected from anionic surfactant, non-ionic surfactant and mixture thereof; a corrosion inhibitor selected from an azole compound, a thiol compound, a sugar alcohol such as xylitol and sorbitol; and a chelating agent.

A cleaning composition according to the present invention is made by blending raw materials in a blending tank. Preferably, the temperature is controlled to be below 40 °C while blending to avoid undesired side reactions and evaporation of any raw material. A closed system is preferred for blending to avoid evaporation of any raw material.

A composition according to the present invention has pH from 8.0 to 11.0, preferably from 8.5 to 10.5. pH is measured by using Glass-Electrode Method from 10% aqueous solutions and undiluted solutions at room temperature. pH is measured by using pH meter (Model: F-51), manufactured by Horiba, Ltd.

pH from 8.0 to 11.0 is preferred because it provides a balance between cleaning efficiency and damage on metal surfaces (Al, AlCu, Cu) and dielectric material (SiO₂). If the pH of the composition is greater than 11.0, the cleaning efficiency is decreased and causes damage on metal surfaces. On the other hand, if the pH of the composition is lower than 8.0, it causes damage on dielectric material (SiO₂).

A composition according to the present invention can be used in semiconductor cleaning, preferably in semiconductor batch cleaning, semiconductor batch spray cleaning, in semiconductor brush cleaning and in semiconductor single wafer cleaning, more preferably in semiconductor single wafer cleaning.

The present invention relates to a process of removing one or more of etching residue, residual photoresist, and photoresist by-products from a substrate, comprising steps of: contacting a substrate having one or more of etching residue, residual photoresist, and photoresist by-products present thereon with a composition according to the present invention.

### Examples

pH is measured by using Glass-Electrode Method from 10% aqueous solutions and undiluted solutions at room temperature. pH is measured by using pH meter (Model: F-51), manufactured by Horiba, Ltd.

AlCu etching rates (ER) were determined from process time and thickness loss of AlCu film formed on silicon wafer. The thickness of AlCu film was measured by using RT-70 four-point probe manufactured by Napson Corporation. After determining the initial AlCu thickness, test wafers were immersed in the test solution at 25 °C. After 30 minutes the test wafers were removed from the test solution, rinsed for three minutes with deionized water and dried completely under nitrogen. Subsequently, AlCu thickness was measured to determine the thickness loss by immersion in the test solutions.

TEOS etching rates (ER) were determined from process time and thickness loss of TEOS film formed on silicon wafer. The thickness of TEOA film was measured by using an optical thickness monitor (Model: FE-3000), manufactured by Otsuka electronics co. Ltd. After determining the initial TEOS thickness, test wafers were immersed in the test solution at 25 °C. After 30 minutes the test wafers were removed from the test solution, rinsed for three minutes with deionized water and dried completely under nitrogen. Subsequently, TEOS thickness was measured to determine the thickness loss by immersion in the test solutions.

AlCu coated wafer: wafers were coated 300nm with vapor-deposited AlCu alloy (Al: 99.5%, Cu: 0.5%) films commercially available.

TEOS coated wafer: wafers coated 100nm with silicon dioxide film made by chemical vapor deposition of tetraethyl orthosilicate commercially available.

The coated wafers were diced into 2.5cm ×2.5cm pieces and immersed in the test solution at 25 °C.

Table 1 exemplifies in examples 1 - 8 the cleaning composition according to the present invention. All of these examples have a high concentration of ammonium fluoride and stable pH value, in addition none of the compositions case a damage to TEOS and AlCu surfaces.

Figure 1 illustrates a relationship between water and AlCu etching rate (ER). Figure 1 contains AlCu ER data of composition of comparative examples 14 and example 1 to 5.

As illustrated in Figure 1, AlCu ER of the comparative example 14 was unexpectedly high. Furthermore, AlCu ER was suddenly decreased along with water concentration. Indication that water concentration of the present invention is very important.

**Table 1**

| Example | 1 | 2 | 3 | 4 | 5 | 6 | 7 | 8 |
|---|---|---|---|---|---|---|---|---|
| Ammonium fluoride | 3 | 3 | 3 | 3 | 3 | 3 | 3 | 3 |
| DMSO | 30 | 29 | 26.5 | 24 | 19 | 20 | 20 | 20 |
| NMP | 30 | 29 | 26.5 | 24 | 19 | 40 | 38 | 32.5 |
| TEA | 4.5 | 4.5 | 4.5 | 4.5 | 4.5 | 2.5 | 4.5 | 10 |
| Water | 32.5 | 34.5 | 39.5 | 44.5 | 54.5 | 34.5 | 34.5 | 34.5 |
| Solubility | soluble | soluble | soluble | soluble | soluble | soluble | soluble | soluble |
| pH | 8.9 | 8.9 | 8.9 | 8.8 | 8.8 | 8.8 | 8.9 | 9.1 |
| pH 10% | 8.4 | 8.4 | 8.4 | 8.4 | 8.4 | 8.2 | 8.4 | 8.6 |
| AlCu ER (A/min) | 8.3 | 3.7 | 2.2 | 1.9 | 3.7 | 6.8 | 4.8 | 3.7 |
| TEOS ER (A/min) | 2.3 | 1.5 | 0.4 | 0.2 | 0.2 | 3 | 1.7 | 1.1 |

Table 2 exemplifies comparative examples (5 - 10) of cleaning composition. These examples have concerns such as solubility of ammonium fluoride, pH stability, AlCu or TEOS etching rate (silicon dioxide film made by chemical vapor deposition of tetraethyl orthosilicate).

**Table 2**

| COMPARATIVE EXAMPLE | 9 | 10 | 11 | 12 | 13 | 14 |
|---|---|---|---|---|---|---|
| Ammonium fluoride | 3 | 3 | 3 | 3 | 1 | 3 |
| DMSO | 70 | 33.5 | 20 | 20 | 70 | 31.25 |
| NMP | | 33.5 | 42.5 | 42.4 | | 31.25 |
| TEA | | | 0 | 0.1 | | 4.5 |
| Water | 27 | 30 | 34.5 | 34.5 | 29 | 30 |
| Solubility | insoluble | insoluble | soluble | soluble | soluble | soluble |
| pH | - | - | 8.3 | 8.4 | | 9 |
| pH 10% | - | - | 6.0 | 7.1 | | 8.5 |
| AlCu ER | | 15.2 | | | | 13.9 |
| TEOS ER | | 8.8 | 9.9 | 9.2 | | 3.9 |

## Claims

1. A cleaning composition comprising
a) from 1 to 5% by weight of total weight of the composition of ammonium fluoride;
b) from 30 to 70% by weight of total weight of the composition of a water soluble organic solvent;
c) from 1.5 to 20% by weight of total weight of the composition of organic amine; and
d) from 31 to 60% by weight of total weight of the composition of deionised water.

2. A composition according to claim 1, wherein said composition comprises from 2 to 4% by weight of total weight of the composition of ammonium fluoride, preferably from 2.5 to 3.5%.

3. A composition according to claim 1 or 2, wherein said water soluble organic solvent is selected from the group consisting of N-methylpyrrolidone, dimethyl sulfoxide, methyl diglycol, buthyl diglycol, N,N-dimethylformamide, N,N-dimethylacetamide, γ-butyrolactone, ethylene glycol, propylene glycol and mixtures thereof, preferably said solvent is selected from N-methylpyrrolidone, dimethyl sulfoxide and mixtures thereof.

4. A composition according to any of claims 1 to 3, wherein said composition comprises from 35 to 65% by weight of total weight of the composition of a water soluble organic solvent, preferably from 45 to 65%, more preferably from 50 to 61%.

5. A composition according to any of claims 1 to 4, wherein said organic amine is selected from the group consisting of monoethanolamine, diethanolamine, triethanolamine, monoisopropanolamine, 2-(2-aminoethylamino) ethanol, 2-Amino-2-methyl-1-propanol, N-methylethanolamine, 2-(dimethylamino)ethanol, ethylenediamine, propylenediamine and mixtures thereof, preferably said organic amine is triethanolamine.

6. A composition according to any of claims 1 to 5, wherein said composition comprises from 2 to 15% by weight of total weight of the composition of an organic amine, preferably from 2.5 to 12.5% and more preferably from 3.5 to 5%.

7. A composition according to any of claims 1 to 6, wherein said composition comprises from 32 to 50% by weight of total weight of the composition of deionised water, preferably from 32 to 45%, more preferably from 32 to 40%.

8. A composition according to any of claims 1 to 7, further comprising an organic acid selected from the group consisting of formic acid, acetic acid, propionic acid, butyric acid, isobutyric acid, oxalic acid, malonic acid, succinic acid, glutaric acid, maleic acid, fumaric acid, benzoic acid, phthalic acid, 1,2,3-benzenetricarboxylic acid, glycolic acid, lactic acid, malic acid, citric acid, tartaric acid, gluconic acid, glyoxylic acid, gallic acid and mixtures thereof.

9. A composition according to any of claims 1 to 8, having pH from 8.0 to 11.0, preferably from 8.5 to 10.5.

10. Use of a composition according to any of claims 1 to 9 in semiconductor cleaning, preferably in semiconductor batch cleaning, semiconductor batch spray cleaning, in semiconductor brush cleaning and in semiconductor single wafer cleaning, more preferably in semiconductor single wafer cleaning.

11. A process of removing one or more of etching residue, residual photoresist, and photoresist by-products from a substrate, comprising steps of:
contacting a substrate having one or more of etching residue, residual photoresist, and
photoresist by-products present thereon with a composition according to any of claims 1 to 9.
